# EUROPÄISCHE PATENTSCHRIFT

(11) **EP 2 396 140 B1**
(45) Veröffentlichungstag und Bekanntmachung des Hinweises auf die Patenterteilung: **16.01.2013**
(21) Anmeldenummer: 10754423.1
(22) Anmeldetag: 03.09.2010
(51) Int. Cl.: B23K 35/02, B23K 35/34, B23K 35/36, B23K 35/365, B22F 1/00, B22F 7/04

(54) **METALLPASTE MIT OXIDATIONSMITTELN**
METAL PASTE WITH OXIDATION AGENTS
PÂTE MÉTALLIQUE CONTENANT DES AGENTS OXYDANTS

(30) Priorität: 04.09.2009 DE 102009040076
(43) Veröffentlichungstag der Anmeldung: 21.12.2011
(73) Patentinhaber: Heraeus Materials Technology GmbH & Co. KG, 63450 Hanau (DE)
(72) Erfinder: SCHÄFER, Michael, 36093 Künzell (DE); SCHMITT, Wolfgang, 63110 Rodgau (DE); ZENG, Jian, 59555 Lippstadt (DE)
(74) Vertreter: Brand, Normen
(86) Internationale Anmeldenummer: PCT/EP2010/005399
(87) Internationale Veröffentlichungsnummer: WO 2011/026623

(56) Entgegenhaltungen:
- EP-A1- 1 950 767
- WO-A1-95/20460
- DE-A1-102005 053 553
- JP-A- 2004 283 841

## Beschreibung

Die vorliegende Erfindung betrifft eine Metallpaste und ein Verfahren zum Verbinden von Bauelementen, bei dem diese Metallpaste eingesetzt wird.

Im Bereich der Leistungselektronik stellt das Verbinden von Bauelementen, wie LEDs oder sehr dünnen Siliziumchips, die eine hohe Druck- und Temperaturempfindlichkeit aufweisen, eine besondere Herausforderung dar.

Aus diesem Grund werden solche druck- und temperaturempfindlichen Bauelemente häufig durch Kleben miteinander verbunden. Die Klebetechnik besitzt jedoch den Nachteil, dass damit Kontaktstellen zwischen den Bauelementen geschaffen werden, die nur eine unzureichende Wärmeleitfähigkeit bzw. elektrische Leitfähigkeit aufweisen.

Um dieses Problem zu lösen, werden die zu verbindenden Bauelemente häufig gesintert. Die Sintertechnik stellt ein sehr einfaches Verfahren zum stabilen Verbinden von Bauelementen dar.

Herkömmliche Sinterverfahren benötigen jedoch entweder einen hohen Prozessdruck oder aber eine hohe Prozesstemperatur. Diese Bedingungen führen häufig zu Schädigungen der zu verbindenden Bauelemente, so dass herkömmliche Sinterverfahren für viele Anwendungen ausscheiden.

In der DE 10 2007 046 901 A1 wird eine Sintertechnik vorgeschlagen, mit der es gelingt, sehr gut elektrisch leitende und wärmeleitende Verbindungsschichten für die Leistungselektronik aufzubauen. Bei diesem Sinterverfahren wird eine Metallpaste verwendet, die eine Silberverbindung enthält, die sich unter 300°C zu elementarem Silber zersetzt. Diese Metallpasten ermöglichen eine Verringerung des Prozessdrucks auf unter 3 bar und eine Verringerung der Prozesstemperatur auf unter 250°C. Diese Sintertechnik stellt einen großen Qualitätssprung bei der Verbindung von druck- und temperaturempfindlichen Bauelementen dar.

EP1950767 A1 offenbart eine Metallpaste mit Silberpartikeln, zur Herstellung von elektrischen Verbindungen mittels Sintern. Die Silberpartikel sind zumindest teilweise mit einer Fettsäure beschichtet, um ein Agglomerieren der Partikel zu verhindern.

Allerdings wäre es für viele Anwendungen wünschenswert, wenn die Prozesstemperatur noch weiter gesenkt werden könnte. Dies würde zu einer geringeren Belastung der zu verbindenden Bauelemente und damit zu einer weiteren Qualitätssteigerung von Bauteilen auf dem Gebiet der Leistungselektronik sorgen. Darüber hinaus könnten bei einer weiteren Senkung der Prozesstemperatur in erheblichem Maße Energiekosten eingespart werden.

Der vorliegenden Erfindung liegt daher die Aufgabe zugrunde, ein Sinterverfahren bereitzustellen, das es erlaubt, Bauelemente auf stabile Weise miteinander zu verbinden, wobei die Prozesstemperatur bei unter 200°C liegt. Dabei sollen Kontaktstellen zwischen den zu verbindenden Bauelementen gebildet werden, die eine niedrige Porosität und eine hohe elektrische und thermische Leitfähigkeit aufweisen.

Eine weitere Aufgabe der vorliegenden Erfindung besteht darin, eine Metallpaste bereitzustellen, die in dem erfindungsgemäßen Sinterverfahren verwendet werden kann, und die eine Erniedrigung der Prozesstemperatur auf unter 200°C und die die Bildung von Kontaktstellen zwischen den zu verbindenden Bauelementen mit niedriger Porosität und hoher elektrischer und thermischer Leitfähigkeit ermöglicht.

Diese Aufgaben werden gelöst durch die Gegenstände der unabhängigen Ansprüche.

Demnach wird ein Verfahren zum Verbinden von Bauelementen zur Verfügung gestellt, bei dem man (a) eine Sandwichanordnung bereitstellt, die wenigstens (a1) ein Bauelement 1, (a2) ein Bauelement 2 und (a3) eine Metallpaste aufweist, die sich zwischen Bauelement 1 und Bauelement 2 befindet, und (b) die Sandwichanordnung sintert, dadurch gekennzeichnet, dass die Metallpaste (A) 75 - 90 Gewichtsprozent wenigstens eines Metalls, das in Form von Partikeln vorliegt, die ein Coating aufweisen, das wenigstens eine organische Verbindung enthält, (B) 0 - 12 Gewichtsprozent wenigstens eines Metallprecursors, (C) 6 - 20 Gewichtsprozent wenigstens eines Lösungsmittels und (D) 0,1 -15 Gewichtsprozent wenigstens eines Sinterhilfsmittels, das aus der Gruppe ausgewählt ist, bestehend aus (i) organischen Peroxiden, (ii) anorganischen Peroxiden und (iii) anorganischen Säuren, umfasst.

Ferner wird eine Metallpaste zur Verfügung gestellt, die (A) 75 - 90 Gewichtsprozent wenigstens eines Metalls, das in Form von Partikeln vorliegt, die ein Coating aufweisen, das wenigstens eine organische Verbindung enthält, (B) 0 - 12 Gewichtsprozent wenigstens eines Metallprecursors, (C) 6 - 20 Gewichtsprozent wenigstens eines Lösungsmittels und (D) 0,1 - 15 Gewichtsprozent wenigstens eines Sinterhilfsmittels, das aus der Gruppe ausgewählt ist, bestehend aus (i) organischen Peroxiden, (ii) anorganischen Peroxiden und (iii) anorganischen Säuren, enthält.

Außerdem bezieht sich die Erfindung auf die Verwendung eines Sinterhilfsmittels, das aus der Gruppe ausgewählt ist, bestehend aus (i) organischen Peroxiden, (ii) anorganischen Peroxiden und (iii) anorganischen Säuren, für einen Sinterprozess zum Verbinden von Bauelementen, die in einer Sandwichanordnung über die Metallpaste miteinander in Kontakt stehen.

Die nachstehenden Erläuterungen sollen die Erfindung nicht einschränken, sondern bieten nur eine mögliche Erklärung für die Wirkungsweise der Erfindung.

Die vorliegende Erfindung beruht auf der Erkenntnis, dass es für das Sintern von Bauelementen unter Verwendung von Metallpasten vorteilhaft ist, wenn die in der Metallpaste enthaltenen Partikel, vorzugsweise mit Fettsäuren, gecoatet sind. Sind die Metallpartikel nicht gecoatet, dann kommt es zu einer Agglomeration der Metallpartikel in der Metallpaste und zu einer Verklumpung der Metallpartikel in einem frühen Stadium während des Sinterprozesses. Dies hat oft inhomogene Kontaktstellen zwischen den zu verbindenden Bauelementen zur Folge.

Überraschenderweise wurde herausgefunden, dass derart gecoatete Metallpartikel allerdings auch ursächlich dafür sind, dass die Sintertemperatur nicht auf unter 200°C gesenkt werden kann. Solange sich die Coatingverbindungen auf der Oberfläche der Metallpartikel befinden, wird zwar einerseits eine Agglomeration der Metallpartikel verhindert. Andererseits stehen aber auch die Oberflächen der Metallpartikel nicht für den Sintervorgang zur Verfügung, so dass die Metallpartikel nicht gesintert werden können.

In herkömmlichen Sinterverfahren werden die Coatingverbindungen bei den üblicherweise für das Sintern verwendeten Temperaturen von weit über 200°C im Laufe des Sinterprozesses abgebrannt. Erst nach dem Abbrennen der Coatingverbindungen sind die Oberflächen der Metallpartikel für den Sinterprozess zugänglich. Daher sind Sinterprozesse mit den herkömmlich eingesetzten, gecoateten Metallpartikeln erst bei Temperaturen von weit oberhalb von 200°C möglich.

Überraschenderweise wurde gefunden, dass bestimmte Sinterhilfsmittel ein Abbrennen der Coatingverbindungen bei Temperaturen von unter 200°C gewährleisten. Bei diesen Sinterhilfsmitteln handelt es sich vorzugsweise um sauerstoffhaltige Oxidationsmittel, die sicherstellen, dass die auf den Metallpartikeln enthaltenen Coatingverbindungen bei Temperaturen unterhalb von 200°C entfernt werden. Somit stehen bereits bei Temperaturen von unter 200°C die Oberflächen der Metallpartikel für den Sinterprozess zur Verfügung. Ebenfalls überraschend war, dass es trotz des Abbrennens der Coatingverbindungen bei Temperaturen von unter 200°C nicht zu einer Agglomeration der Metallpartikel kommt, sondern homogene und stabile Kontaktstellen zwischen den zu verbindenden Bauelementen entstehen.

Ferner wurde ebenfalls überraschenderweise gefunden, dass die unter der Coatingschicht liegende Oberfläche der Metallpartikel zumeist wenigstens zu einem Teil oxidiert ist. Solche Metalloxidschichten beeinträchtigen die für das Sintern erforderlichen Diffusionsprozesse und haben somit eine Verlangsamung der Diffusionsgeschwindigkeit zur Folge. Aus diesem Grund ist es beim Sintern mittels dieser an der Oberfläche oxidierten Metallpartikel herkömmlicherweise nötig, hohe Prozesstemperaturen von weit über 200°C zu verwenden.

Erfindungsgemäß entsteht beim Abrennen der Coatingverbindungen unter anderem Kohlenmonoxid. Das während dem Sintern freigesetzte Kohlenmonoxid ist ein Reduktionsmittel und als solches in der Lage, das auf der Oberfläche der Metallpartikel vorhandene Metalloxid zu reduzieren. Die Entfernung des Metalloxids gewährleistet eine behinderungsfreie Diffusion und damit einhergehend eine Steigerung der Diffusionsgeschwindigkeit. Bei dieser Reduktion des Metalloxids wird außerdem in situ reaktives Metall erzeugt, das den Sinterprozess weiter begünstigt. Ferner kann dieses reaktive Metall während des Sinterprozesses zwischen den Metallatomen der Metallpartikel vorhandene Lücken auffüllen und so die Porosität der Kontaktstelle zwischen den zu verbindenden Bauelementen signifikant erniedrigen. Dadurch werden äußerst stabile und wärmeleitfähige sowie elektrisch leitfähige Kontaktstellen erzeugt.

Durch den Einsatz der erfindungsgemäßen Sinterhilfsmittel kann somit die Prozesstemperatur beim Sintern signifikant reduziert werden. Überraschend ist dabei, dass es trotz des Abbrennens der Coatingverbindungen bei Temperaturen von unter 200°C nicht zu einer Agglomeration der Metallpartikel kommt, sondern homogene und stabile Kontaktstellen zwischen den zu verbindenden Bauelementen entstehen.

Die vorstehend beschriebenen Effekte scheinen im Ergebnis dazu zu führen, dass es bei Verwendung der eingesetzten Sinterhilfsmittel gelingt, die Sintertemperatur auf unter 200°C zu erniedrigen und trotzdem stabile und wärmeleitfähige sowie elektrisch leitfähige Kontaktstellen zwischen den durch den Sinterprozess zu verbindenden Bauelementen zu erzeugen.

Der Einsatz von Metallpasten in einem Sinterprozess zum Verbinden von Bauelementen im Bereich der Leistungselektronik ist bekannt.

Erfindungsgemäß enthält die Metallpaste wenigstens ein Metall.

Unter den Begriff Metall fallen vorliegend sowohl reine Metalle als auch Metalllegierungen.

Im Rahmen der Erfindung bezieht sich der Begriff Metall auf ein Element, das im Periodensystem der Elemente in der selben Periode wie Bor, aber links von Bor, in der selben Periode wie Silicium, aber links von Silicium, in der selben Periode wie Germanium, aber links von Germanium, und in der selben Periode wie Antimon, aber links von Antimon steht, sowie auf alle Elemente, die eine höhere Ordnungszahl als 55 aufweisen.

Als reine Metalle werden erfindungsgemäß Metalle verstanden, die ein Metall mit einer Reinheit von wenigstens 95 Gewichtsprozent, bevorzugt wenigstens 98 Gewichtsprozent, mehr bevorzugt wenigstens 99 Gewichtsprozent und noch mehr bevorzugt wenigstens 99,9 Gewichtsprozent enthalten.

Gemäß einer bevorzugten Ausführungsform handelt es sich bei dem Metall um Kupfer, Silber, Gold, Nickel, Palladium, Platin oder Aluminium.

Als Metalllegierungen werden erfindungsgemäß metallische Gemische aus wenigstens zwei Komponenten verstanden, von denen wenigstens eine ein Metall ist.

Gemäß einer bevorzugten Ausführungsform wird erfindungsgemäß als Metalllegierung eine Legierung eingesetzt, die Kupfer, Aluminium, Nickel und/oder Edelmetalle enthält. Die Metalllegierung umfasst vorzugsweise wenigstens ein Metall, das aus der Gruppe ausgewählt ist, die aus Kupfer, Silber, Gold, Nickel, Palladium, Platin und Aluminium besteht. Besonders bevorzugte Metalllegierungen enthalten wenigstens zwei Metalle, die aus der Gruppe ausgewählt sind, die aus Kupfer, Silber, Gold, Nickel, Palladium, Platin und Aluminium besteht. Es kann ferner bevorzugt sein, dass der Anteil der Metalle, die aus der Gruppe ausgewählt sind, die aus Kupfer, Silber, Gold, Nickel, Palladium, Platin und Aluminium besteht, an der Metalllegierung wenigstens 90 Gewichtsprozent, vorzugsweise wenigstens 95 Gewichtsprozent, mehr bevorzugt wenigstens 99 Gewichtsprozent und noch mehr bevorzugt 100 Gewichtsprozent beträgt. Bei der Legierung kann es sich beispielsweise um eine Legierung handeln, die Kupfer und Silber, Kupfer, Silber und Gold, Kupfer und Gold, Silber und Gold, Silber und Palladium, Platin und Palladium oder Nickel und Palladium enthält.

In der erfindungsgemäßen Metallpaste können als Metall ein reines Metall, mehrere Arten von reinen Metallen, eine Art von Metalllegierung, mehrere Arten von Metalllegierungen oder Mischungen davon enthalten sein.

Das Metall liegt in der Metallpaste in Form von Partikeln vor.

Die Metallpartikel können von unterschiedlicher Gestalt sein. Beispielsweise können die Metallpartikel in der Form von Flakes oder einer sphärischen (kugeligen) Form vorliegen. Gemäß einer besonders bevorzugten Ausführungsform weisen die Metallpartikel die Form von Flakes auf. Dies schließt jedoch nicht aus, dass von den eingesetzten Metallpartikeln auch ein untergeordneter Anteil eine andere Form aufweisen kann. Es ist jedoch bevorzugt, dass wenigstens 70 Gewichtsprozent, mehr bevorzugt wenigstens 80 Gewichtsprozent, noch mehr bevorzugt wenigstens 90 Gewichtsprozent oder 100 Gewichtsprozent der Partikel in der Form von Flakes vorliegen.

Erfindungsgemäß sind die Metallpartikel gecoatet.

Unter einem Coating von Partikeln wird erfindungsgemäß eine festhaftende Schicht auf der Oberfläche von Partikeln verstanden.

Erfindungsgemäß enthält das Coating der Metallpartikel wenigstens eine Art von Coatingverbindungen.

Bei diesen Coatingverbindungen handelt es sich um organische Verbindungen.

Erfindungsgemäß handelt es sich bei den organischen Verbindungen, die als Coatingverbindungen dienen, um kohlenstoffhaltige Verbindungen, die eine Agglomeration der Metallpartikel verhindern.

Gemäß einer bevorzugten Ausführungsform tragen die als Coatingverbindungen wenigstens eine funktionelle Gruppe. Als funktionelle Gruppen kommen insbesondere Carbonsäuregruppen, Carboxylatgruppen, Estergruppen, Ketogruppen, Aldehydgruppen, Aminogruppen, Amidgruppen, Azogruppen, Imidgruppen, Cyanogruppen oder Nitrilgruppen in Betracht. Bevorzugte funktionelle Gruppen sind Carbonsäuregruppen und Estergruppen. Die Carbonsäuregruppe kann deprotoniert sein.

Bei den Coatingverbindungen mit wenigstens einer funktionellen Gruppe handelt es sich vorzugsweise um gesättigte, einfach ungesättigte oder mehrfach ungesättigte organische Verbindungen.

Diese Coatingverbindungen mit wenigstens einer funktionellen Gruppe können ferner verzweigt oder unverzweigt sein.

Die erfindungsgemäßen Coatingverbindungen mit wenigstens einer funktionellen Gruppe weisen vorzugsweise 1 - 50, mehr bevorzugt 2 - 24, noch mehr bevorzugt 6 - 24 und noch mehr bevorzugt 8 - 20 Kohlenstoffatome auf.

Die Coatingverbindungen können ionisch oder nichtionisch sein.

Vorzugsweise kommen als Coatingverbindungen freie Fettsäuren, Fettsäuresalze oder Fettsäureester zum Einsatz.

Die freien Fettsäuren, Fettsäuresalze und Fettsäureester sind vorzugsweise unverzweigt.

Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Aluminium, Kupfer, Lithium, Natrium und Kalium.

Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 - 24, mehr bevorzugt 10 - 24 und noch mehr bevorzugt 12 - 18 Kohlenstoffatomen.

Bevorzugte Coatingverbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäureilcosansäure), Behensäure (Docosansäure), Lignocerinsäure (Tetracosansäure) sowie die entsprechenden Ester und Salze.

Besonders bevorzugte Coatingverbindungen sind Dodecansäure, Octadecansäure, Aluminiumstearat, Kupferstearat, Natriumstearat, Kaliumstearat, , Natriumpalmitat und Kaliumpalmitat.

Die erfindungsgemäß verwendeten Coatingverbindungen werden mittels herkömmlicher und aus dem Stand der Technik bekannter Verfahren auf die Oberfläche der Metallpartikel aufgetragen.

Beispielsweise ist es möglich, die Coatingverbindungen, insbesondere die vorstehend erwähnten Stearate oder Palmitate, in Lösungsmitteln aufzuschlämmen und die aufgeschlämmten Coatingverbindungen in Kugelmühlen mit den Metallpartikeln zu vermahlen. Nach dem Mahlen werden die nun mit den Coatingverbindungen beschichteten Metallpartikel getrocknet und anschließend entstaubt.

Vorzugsweise beträgt der Anteil an organischen Verbindungen, insbesondere der Anteil an Verbindungen, die aus der Gruppe ausgewählt sind, die aus freien Fettsäuren, Fettsäuresalzen und Fettsäureestern besteht, die vorzugsweise 8 - 24, mehr bevorzugt 10 - 24 und noch mehr bevorzugt 12 - 18 Kohlenstoffatome aufweisen, an dem gesamten Coating wenigstens 60 Gewichtsprozent, mehr bevorzugt wenigstens 70 Gewichtsprozent, noch mehr bevorzugt wenigstens 80 Gewichtsprozent, noch mehr bevorzugt wenigstens 90 Gewichtsprozent, insbesondere wenigstens 95 Gewichtsprozent, wenigstens 99 Gewichtsprozent oder 100 Gewichtsprozent.

Üblicherweise beträgt der Anteil der Coatingverbindungen, vorzugsweise der Coatingverbindungen, die aus der Gruppe ausgewählt sind, die aus freien Fettsäuren, Fettsäuresalzen und Fettsäureestern mit 8 - 24, mehr bevorzugt 10 - 24 und noch mehr bevorzugt 12 - 18 Kohlenstoffatomen besteht, 0,01 - 2 Gewichtsprozent, vorzugsweise 0,3 - 1,5 Gewichtsprozent, mehr bevorzugt 0,4 - 1,4 Gewichts-prozent und noch mehr bevorzugt 0,5 - 1,0 Gewichtsprozent, bezogen auf das Gewicht der gecoateten Metallpartikel.

Der Coatinggrad, der als Verhältnis der Masse an Coatingverbindungen zur Oberfläche der Metallpartikel definiert ist, beträgt vorzugsweise 0,00005 - 0,03 g, mehr bevorzugt 0,0001 - 0,02 g und noch mehr bevorzugt 0,0005 - 0,02 g an Coatingverbindungen pro Quadratmeter (m²) Oberfläche der Metallpartikel.

Die erfindungsgemäße Metallpaste umfasst neben den gecoateten Metallpartikeln vorzugsweise wenigstens einen Metallprecursor.

Unter Metallprecursor wird im Rahmen der Erfindung eine Verbindung verstanden, die wenigstens ein Metall enthält. Vorzugsweise handelt es sich dabei um eine Verbindung, die sich bei Temperaturen von unter 200°C unter Freisetzung eines Metalls zersetzt. Vorzugsweise wird demnach bei Verwendung eines Metallprecursors beim Sinterprozess in situ ein Metall gebildet. Es kann auf einfache Weise ermittelt werden, ob es sich bei einer Verbindung um einen Metallprecursor gemäß dieser bevorzugten Ausführungsform handelt. So kann beispielsweise eine Paste, die eine zu testende Verbindung enthält, auf ein Substrat mit einer Silberoberfläche abgeschieden, auf 200°C erhitzt und bei dieser Temperatur für 20 Minuten belassen werden. Danach wird überprüft, ob sich unter diesen Bedingungen die zu testende Verbindung zu einem Metall zersetzt hat. Hierzu kann beispielsweise vor dem Test der Gehalt der metallhaltigen Pastenbestandteile ausgewogen und daraus die theoretische Masse des Metalls berechnet werden. Nach dem Test wird die Masse des auf dem Substrat abgeschiedenen Materials gravimetrisch bestimmt. Entspricht die Masse des auf dem Substrat abgeschiedenen Materials der theoretischen Masse des Metalls, wobei die üblichen Messabweichungen zu berücksichtigen sind, handelt es sich bei der getesteten Verbindung um einen Metallprecursor gemäß dieser bevorzugten Ausführungsform.

Gemäß einer bevorzugten Ausführungsform handelt es sich bei dem Metallprecursor um einen endotherm zersetzbaren Metallprecursor. Erfindungsgemäß soll unter endotherm zersetzbarem Metallprecursor ein Metallprecursor verstanden werden, dessen thermische Zersetzung, vorzugsweise unter Schutzgasatmosphäre, einen endothermen Vorgang darstellt. Bei dieser thermischen Zersetzung soll es zur Freisetzung von Metall aus dem Metallprecursor kommen.

Gemäß einer weiteren bevorzugten Ausführungsform weist der Metallprecursor ein Metall auf, das auch im Metallpulver enthalten ist.

Vorzugsweise umfasst der Metallprecursor als Metall wenigstens ein Element, das aus der Gruppe ausgewählt ist, die aus Kupfer, Silber, Gold, Nickel, Palladium und Platin besteht.

Es kann bevorzugt sein, als Metallprecursor endotherm zersetzbare Carbonate, Lactate, Formiate, Citrate, Oxide oder Fettsäuresalze, vorzugsweise Fettsäuresalze mit 6 bis 24 Kohlenstoffatomen, der genannten Metalle zu verwenden.

In besonderen Ausführungsformen werden als Metallprecursor Silbercarbonat, Silber(I-)lactat, Silber(II)-formiat, Silbercitrat, Silberoxid (zum Beispiel AgO oder Ag₂O), Kupfer(II)-lactat, Kupferstearat, Kupferoxide (zum Beispiel Cu₂O oder CuO) oder Goldoxide (zum Beispiel Au₂O oder AuO) eingesetzt.

Gemäß einer besonders bevorzugten Ausführungsform wird als Metallprecursor Silbercarbonat, Silber(I)-oxid oder Silber(II)-oxid verwendet.

Falls vorhanden, liegt der Metallprecursor in der Metallpaste vorzugsweise in der Form eines Pulvers vor, das aus Partikeln besteht.

Die Partikel des Pulvers können die Form von Flakes oder eine sphärische (kugelige) Form aufweisen. Vorzugsweise liegen die Partikel des Metallprecursors jedoch als Flakes vor.

Die Verwendung eines Metallprecursors, der während des Sinterprozesses in situ Metall freisetzt, hat zur Folge, dass das in situ gebildete Metall während des Sinterprozesses Lücken zwischen den in der Metallpaste enthaltenen Metallpartikeln schließt. Auf diese Weise kann die Porosität einer Kontaktstelle zwischen zwei zu verbindenden Bauelementen reduziert werden.

Die erfindungsgemäße Metallpaste enthält ferner wenigstens ein Lösungsmittel.

Unter Lösungsmittel werden erfindungsgemäß Verbindungen verstanden, die andere Verbindungen auf physikalischem Wege zur Lösung bringen können. Bei diesen anderen Verbindungen handelt es sich jedoch vorzugsweise nicht um das Metall der Metallpaste.

Erfindungsgemäß kommen als Lösungsmittel die üblicherweise für Metallpasten verwendeten Lösungsmittel in Betracht.

Vorzugsweise werden als Lösungsmittel organische Verbindungen verwendet, die wenigstens ein Heteroatom tragen und 6 - 24 Kohlenstoffatome, mehr bevorzugt 8 - 20 Kohlenstoffatome, aufweisen.

Diese organischen Verbindungen können verzweigt oder unverzweigt sein. Bei den organischen Verbindungen kann es sich auch um zyklische Verbindungen handeln.

Ferner können die als Lösungsmittel verwendeten organischen Verbindungen gesättigte, einfach ungesättigte oder mehrfach ungesättigte Verbindungen sein.

Das wenigstens eine Heteroatom, das in den organischen Verbindungen, die als Lösungsmittel dienen können, enthalten ist, ist vorzugsweise aus der Gruppe ausgewählt, die aus Sauerstoffatomen und Stickstoffatomen besteht.

Das wenigstens eine Heteroatom kann Teil von wenigstens einer funktionellen Gruppe sein. Als funktionelle Gruppen kommen vorzugsweise Hydroxylgruppen, Carbonsäuregruppen, Estergruppen, Ketogruppen, Aldehydgruppen, Aminogruppen, Amidgruppen, Azogruppen, Imidgruppen, Cyanogruppen oder Nitrilgruppen in Betracht.

Gemäß einer besonders bevorzugten Ausführungsform handelt es sich bei dem verwendeten Lösungsmittel um einen Alkohol.

Gemäß einer besonders bevorzugten Ausführungsform werden als Lösungsmittel α-Terpineol ((R)-(+)-α-Terpineol, (S)-(-)-α-Terpineol oder Racemate), β-Terpineol, γ-Terpineol, δ-Terpineol, Mischungen der vorstehend genannten Terpineole, N-Methyl-2-pyrrolidon, Ethylenglycol, Dimethylacetamid, 1-Tridecanol, 2-Tridecanol, 3-Tridecanol, 4-Tridecanol, 5-Tridecanol, 6-Tridecanol, Isotridecanol und Mischungen dieser Isotridecanole, dibasische Ester (vorzugsweise Dimethylester der Glutar-, Adipin- oder Bernsteinsäure oder Mischungen davon), Glycerin, Diethylenglycol, Triethylenglycol oder Mischungen hiervon verwendet.

Vorzugsweise ist das verwendete Lösungsmittel in der Lage, das in der Metallpaste enthaltene Sinterhilfsmittel zu lösen.

Um ein Absenken der Sintertemperatur auf unter 200°C zu ermöglichen, ist in der erfindungsgemäßen Metallpaste wenigstens ein Sinterhilfsmittel enthalten.

Diese Sinterhilfsmittel gewährleisten, dass die auf den Partikeln des in der Metallpaste enthaltenen Metalls vorhandenen Coatingverbindungen während des Sinterprozesses bei Temperaturen unter 200°C abbrennen.

Bei diesen Sinterhilfsmitteln handelt es sich vorzugsweise um Oxidationsmittel. Unter Oxidationsmittel ist ein Stoff zu verstehen, der andere Stoffe oxidieren kann und dabei selbst reduziert wird. Ein Oxidationsmittel kann Elektronen aufnehmen und ist somit ein Elektronenakzeptor.

Vorzugsweise ist das Sinterhilfsmittel auch ein Sauerstoffüberträger. Damit ist ein Stoff gemeint, der Sauerstoff abgeben kann.

Im Rahmen der Erfindung können als Sinterhilfsmittel (i) organische Peroxide, (ii) anorganische Peroxide und (iii) anorganische Säuren eingesetzt werden. Diese Verbindungen können als Sinterhilfsmittel dienen, da sie wenigstens ein Sauerstoffatom enthalten und ein Verbrennen der Coatingverbindungen, die auf den Metallpartikeln der Metallpaste vorhanden sind, bei einer Temperatur von unter 200°C ermöglichen.

Unter organischen Peroxiden sollen im Rahmen der Erfindung Verbindungen verstanden werden, die das Peroxidanion O₂²⁻ bzw. die Peroxidgruppe -O-O- sowie wenigstens einen organischen Rest enthalten, der direkt mit der Peroxidgruppe verknüpft ist. Organische Peroxide können im Rahmen der Erfindung somit auch anorganische Reste enthalten, die direkt mit der Peroxidgruppe verknüpft sind, solange wenigstens ein organischer Rest vorhanden ist, der direkt mit der Peroxidgruppe verknüpft ist. Diese Verknüpfung ist vorzugsweise kovalenter Natur.

Unter organischen Resten sind vorzugsweise Reste zu verstehen, die wenigstens ein Kohlenstoffatom enthalten, wobei das Kohlenstoffatom mit der Peroxidgruppe direkt, vorzugsweise durch eine kovalente Bindung, verknüpft ist.

Gemäß einer bevorzugten Ausführungsform handelt es sich bei den erfindungsgemäß verwendbaren organischen Peroxiden um Hydroperoxide sowie Peroxycarbonsäuren und deren Salze. Peroxycarbonsäuren leiten sich von Carbonsäuren ab, wobei vorzugsweise die Hydroxylgruppe der Carbonsäureeinheit durch eine Hydroxyperoxylgruppe ersetzt ist. Hydroperoxide wiederum leiten sich formal von Ethern bzw. Alkoholen ab, wobei die Sauerstoffbrücke, die die Alkyl-, Alkenyl- oder Aryl-Reste miteinander oder mit einem Wasserstoffatom verbindet, durch eine Peroxidgruppe ersetzt ist.

Die erfindungsgemäß eingesetzten organischen Peroxide weisen wenigstens eine Peroxidgrappe auf. Sie können somit auch zwei oder mehrere Peroxidgruppen besitzen.

In dem erfindungsgemäß eingesetzten organischen Peroxid können die organischen Reste gleichartig oder verschiedenartig sein.

Die organischen Reste können selbst Heteroatome tragen. In diesem Fall handelt es sich bei den Heteroatomen vorzugsweise um Sauerstoffatome, Stickstoffatome oder Halogenatome. Enthalten die organischen Reste Halogenatome, dann sind Fluoratome, Chloratome, Bromatome oder lodatome bevorzugt. Die Heteroatome können auch Teil einer funktionellen Gruppe sein. Als funktionelle Gruppen kommen vorzugsweise Carbonsäuregruppen, Estergruppen, Ketogruppen, Aldehydgruppen, Hydroxylgruppen, Aminogruppen, Amidgruppen, Azogruppen, Imidgruppen, Cyanogruppen oder Nitrilgruppen in Betracht.

Die organischen Reste der organischen Peroxide weisen vorzugsweise 1 - 20, mehr bevorzugt 2 -15 und noch mehr bevorzugt 2 -10 Kohlenstoffatome auf.

Die organischen Reste können verzweigt oder unverzweigt sein.

Bei den organischen Resten kann es sich um aliphatische oder aromatische Reste handeln.

Im Fall von aliphatischen Resten kann der organische Rest auch einen zyklischen Rest aufweisen. Der Ring des zyklischen Restes besteht vorzugsweise aus 4 - 8 Atomen, wobei es sich vorzugsweise um Kohlenstoffatome handeln kann. Der Ring des zyklischen Restes kann jedoch auch Heteroatome, vorzugsweise ein oder mehrere Stickstoffatome oder Sauerstoffatome enthalten.

Im Fall von aromatischen Resten kann der organische Rest aromatische Gruppen mit vorzugsweise 5 oder 6 Kohlenstoffatomen aufweisen.

Die organischen Reste können gesättigt oder ungesättigt sein. In den organischen Resten können demnach Mehrfachbindungen, vorzugsweise Doppelbindungen, aber auch Dreifachbindungen, enthalten sein.

Die organischen Peroxide können auch wenigstens einen anorganischen Rest enthalten, der direkt mit der Peroxidgruppe verknüpft ist.

Unter anorganischen Resten werden erfindungsgemäß Reste verstanden, die mit der Peroxidgruppe des organischen Peroxids verknüpft sind, wobei die Verknüpfung nicht durch ein Kohlenstoffatom erfolgt.

Die Verknüpfung des anorganischen Restes mit der Peroxidgruppe des organischen Peroxids kann grundsätzlich durch alle Atome außer Kohlenstoffatome erfolgen. Die Verknüpfung erfolgt vorzugsweise durch ein Wasserstoffatom oder ein Heteroatom. Als Heteroatom können Metallatome oder Stickstoffatome bevorzugt sein.

Sind Heteroatome direkt mit der Peroxidgruppe verknüpft, dann kann das Heteroatom Teil eines Restes sein, der neben dem Heteroatom weitere Atome enthält. Bei diesen weiteren Atomen kann es sich vorzugsweise um Kohlenstoffatome, Wasserstoffatome oder weitere Heteroatome handeln, Als weitere Heteroatome können Stickstoffatome, Sauerstoffatome, Phosphoratome und Halogenatome, wie zum Beispiel, Fluoratome, Chloratome, Bromatome oder lodatome, bevorzugt sein.

Als Metallatome, die direkt mit der Peroxidgruppe verknüpft sein können, kommen vorzugsweise Metalle der ersten, zweiten und dritten Gruppe des Periodensystems der Elemente in Betracht. Demnach sind gemäß einer bevorzugten Ausführungsform Lithiumatome, Natriumatome, Kaliumatome, Berylliumatome, Magnesiumatome, Calciumatome, Strontiumatome, Boratome oder Aluminiumatome mit der Peroxidgruppe verknüpft.

Bei dem anorganischen Rest, der über ein Heteroatom mit der Peroxidgruppe verknüpft ist, kann es sich vorzugsweise um einen Ammoniumrest handeln. Es kann auch bevorzugt sein, dass ein oder mehrere Wasserstoffatome des Ammoniumrestes durch organische oder anorganische Gruppen substituiert sind. Vorzugsweise sind ein oder mehrere Wasserstoffatome des Ammoniumrestes durch Alkylgruppen ersetzt. Diese Alkylgruppen können verzweigt oder unverzweigt sein, sind aber vorzugsweise unverzweigt. Die Alkylgruppen, die ein oder mehrere Wasserstoffatome des Ammoniumrestes substituieren, weisen vorzugsweise 1 - 10, mehr bevorzugt 1 - 6 und noch mehr bevorzugt 1 - 4 Kohlenstoffatome auf. Die Alkylgruppen, die ein oder mehrere Wasserstoffatome des Ammoniumrestes substituieren, können gleichartig oder verschiedenartig sein.

Bevorzugte anorganische Reste sind Ammoniumreste, Monomethylammoniumreste, Dimethylammoniumreste, Trimethylammoniumreste, Monoethylammoniumreste, Diethylammoniumreste, Triethylammoniumreste, Monopropylammoniumreste, Dipropylammoniumreste, Tripropylammoniumreste, Monoisopropylammoniumreste, Diisopropylammoniumreste, Triisopropylammoniumreste, Monobutylammoniumreste, Dibutylammoniumreste und Tributylammoniumreste.

Bei dem erfindungsgemäß verwendeten organischen Peroxid kann es sich auch um ein zyklisches organisches Peroxid handeln. Insbesondere kann die Peroxidgruppe des organischen Peroxids selbst Teil eines zyklischen Systems sein.

Die erfindungsgemäß verwendeten organischen Peroxide weisen vorzugsweise eine Zersetzungstemperatur von unter 200°C auf. In diesem Zusammenhang wurde jedoch überraschenderweise festgestellt, dass einige organische Peroxide, die eine Zersetzungstemperatur von über 200°C aufweisen, in Gegenwart von in der Metallpaste enthaltenem Metall eine Zersetzungstemperatur von unter 200°C aufweisen. Dies scheint darauf zurückzuführen sein, dass in der Metallpaste enthaltenes Metall die Zersetzung dieser organischen Peroxide katalysiert.

Es kann ebenfalls bevorzugt sein, dass die erfindungsgemäß eingesetzten organischen Peroxide bei Raumtemperatur (20°C) und Normaldruck (1013 hPa) flüssig sind.

Unter besonders bevorzugten Ausführungsformen handelt es sich bei dem organischen Peroxid um eine Verbindung, die aus der Gruppe ausgewählt ist, die aus Diisobutyryl-peroxid, Cumol-peroxyneodecanoat, 1,1,3,3-Tetramethylbutyl-peroxyneodecanoat, Di-n-propyl-peroxydicarbonat, tert-Amyl-peroxyneodecanoat, Di-(2-ethylhexyl)-peroxydicarbonat, tert-Butyl-peroxyneodecanoat, Di-n-butyl-peroxydicarbonat, 1,1,3,3-Tetramethylbutylperoxypivalat, tert-Butyl-peroxyneoheptanoat, tert-Amyl-peroxypivalat, tert-Butyl-peroxypivalat, Di-(3,5,5-trimethylhexanoyl)-peroxid, tert-Butyl-peroxy-2-ethylhexanoat, tert-Butyl-peroxyisobutyrat, 1,1-Di-(tert-butylperoxy)-3,3,5-trimethylcyclohexan, 1,1-Di-(tert-butylperoxy)-cyclohexan, tert-Butyl-peroxy-3,5,5-trimethylhexanoat, 2,2-Di-(tert-butylperoxy)-butan, tert-Butylperoxyisopropylcarbonat, tert-Butyl-peroxyacetat, 2,5-Dimethyl-2,5-di(2-ethylhexanoylperoxy)-hexan, 1,1,3,3-Tetramethylbutyl-peroxy-2-ethylhexanoat, tert-Amyl-peroxy-2-ethylhexanoat, tert-Butyl-peroxydiethylacetat, tert-Amyl-peroxy-2-ethylhexylcarbonat, tert-Butyl-peroxy-2-ethylhexylcarbonat, tert-Butyl-peroxybenzoat, Di-tert-amylperoxid, 2,5-Dimethyl-2,5-di-(tert-butylperoxy)-hexan, tert-Butylcumyl-peroxid, 2,5-Dimethyl-2,5-di(tert-butylperoxy)hexyn-3, Di-tert-butyl-peroxid, 3,6,9-Triethyl-3,6,9-trimethyl-1,4,7-triperoxonan, Di-isopropylbenzen-mono-hydroperoxid, p-Menthanhydroperoxid, Cumolhydroperoxid, Dicumylperoxid und 1,1,3,3-Tetramethylbutyl-hydroperoxid besteht.

Als Sinterhilfsmittel können ferner auch anorganische Peroxide verwendet werden.

Unter anorganischen Peroxiden werden im Rahmen der Erfindung Verbindungen verstanden, die das Peroxidanion O₂²⁻ bzw. die Peroxidgruppe -O-O- sowie ausschließlich anorganische Reste enthalten. Im Rahmen der Erfindung sind anorganische Peroxide vorzugsweise alle Peroxide, die keine organischen Peroxide sind. Anorganische Reste sind erfindungsgemäß Reste, die direkt mit der Peroxidgruppe über ein anderes Atom als ein Kohlenstoffatom verknüpft sind.

Zwei anorganische Reste, die mit einer Peroxidgruppe des anorganischen Peroxids verbunden sind, können gleichartig oder verschiedenartig sein.

Die Verknüpfung mit der Peroxidgruppe kann vorzugsweise durch ein oder mehrere Wasserstoffatome und/oder ein oder mehrere Heteroatome erfolgen. Als Heteroatome können Metallatome, Boratome oder Stickstoffatome bevorzugt sein.

Sind Heteroatome direkt mit der Peroxidgruppe verknüpft, dann kann das Heteroatom Teil eines Restes sein, der neben dem Heteroatom weitere Atome enthält. Bei diesen weiteren Atomen kann es sich gemäß einer bevorzugten Ausführungsform um Kohlenstoffatome, Wasserstoffatome oder weitere Heteroatome handeln, Als weitere Heteroatome können Stickstoffatome, Sauerstoffatome, Phosphoratome und Halogenatome, insbesondere Fluoratome, Chloratome, Bromatome oder lodatome, bevorzugt sein.

Bevorzugte Metallatome, die direkt mit der Peroxidgruppe verknüpft sein können, sind Metalle der ersten, zweiten und dritten Gruppe des Periodensystems der Elemente. Folglich kann es bevorzugt sein, das Lithiumatome, Natriumatome, Kaliumatome, Berylliumatome, Magnesiumatome, Calciumatome, Strontiumatome, Boratome oder Aluminiumatome mit der Peroxidgruppe verknüpft sind.

Vorzugsweise handelt es sich bei dem wenigstens einen anorganischen Rest, der über ein Heteroatom mit der Peroxidgruppe des anorganischen Peroxids verknüpft ist, um einen Ammoniumrest. Sind in dem anorganischen Peroxid zwei Ammoniumreste mit einer Peroxidgruppe verbunden, dann können die Ammoniumreste gleichartig oder verschiedenartig sein.

Es kann auch bevorzugt sein, dass ein oder mehrere Wasserstoffatome des Ammoniumrestes durch organische oder anorganische Gruppen substituiert sind. Vorzugsweise sind in diesem Fall ein oder mehrere Wasserstoffatome des Ammoniumrestes durch Alkylgruppen ersetzt. Diese Alkylgruppen können verzweigt oder unverzweigt sein, sind aber vorzugsweise unverzweigt. Die Alkylgruppen, die ein oder mehrere Wasserstoffatome des Ammoniumrestes substituieren, weisen vorzugsweise 1 - 10, mehr bevorzugt 1 - 6 und noch mehr bevorzugt 1 - 4 Kohlenstoffatome auf. Die Alkylgruppen, die ein oder mehrere Wasserstoffatome des Ammoniumrestes substituieren, können gleichartig oder verschiedenartig sein.

Bevorzugte anorganische Reste sind Ammoniumreste, Monomethylammoniumreste, Dimethylammoniumreste, Trimethylammoniumreste, Monoethylammoniumreste, Diethylammoniumreste, Triethylammoniumreste, Monopropylammoniumreste, Dipropylammoniumreste, Tripropylammoniumreste, Monoisopropylammoniumreste, Diisopropylammoniumreste, Triisopropylammoniumreste, Monobutylammoniumreste, Dibutylammoniumreste und Tributylammoniumreste.

Bei dem anorganischen Peroxid kann es sich auch um ein Peroxoborat handeln. Unter Peroxoborate werden erfindungsgemäß Borate verstanden, in denen wenigstens ein Sauerstoffatom durch eine Peroxidgruppe ersetzt ist. Borate sind erfindungsgemäß Salze oder Ester der Borsäure. Die Peroxoborate können vorzugsweise auch als Hydrate vorliegen. Ferner kann es sich bei den Peroxoboraten um Peroxosalze mit ringförmigem Anion handeln.

Bevorzugte Peroxoborate sind Ammoniumperborate, Alkylammoniumperborate und Alkaliperborate.

Erfindungsgemäß fallen unter den Begriff Alkylammoniumperborate Ammoniumperborate, in denen ein oder mehrere Wasserstoffatome der Ammoniumeinheit durch ein oder mehrere Alkylgruppen ersetzt sind. Diese Alkylgruppen können verzweigt oder unverzweigt sein. Vorzugsweise weisen diese Alkylgruppen 1 - 10 Kohlenstoffatome, mehr bevorzugt 1 - 6 Kohlenstoffatome und noch mehr bevorzugt 1 - 4 Kohlenstoffatome auf.

Bevorzugte Alkaliperborate sind Lithiumperborat, Kaliumperborat und Natriumperborat.

Die erfindungsgemäß verwendeten anorganischen Peroxide weisen vorzugsweise eine Zersetzungstemperatur von nicht mehr als 200°C auf.

Ferner kann es bevorzugt sein, dass die erfindungsgemäß eingesetzten anorganischen Peroxide bei Raumtemperatur (20°C) und Normaldruck (1013 hPa) flüssig sind.

Gemäß einer besonders bevorzugten Ausführungsform werden als anorganische Peroxide Wasserstoffperoxid, Ammoniumperoxid, Monomethylammoniumperoxid, Dimethylammoniumperoxid, Trimethylammoniumperoxid, Monoethylammoniumperoxid, Diethylammoniumperoxid, Triethylammoniumperoxid, Monopropylammoniumperoxid, Dipropylammoniumperoxid, Tripropylammoniumperoxid, Monoisopropylammoniumperoxid, Diisopropylammoniumperoxid, Triisopropylammoniumperoxid, Monobutylammoniumperoxid, Dibutylammoniumperoxid, Tributylammoniumperoxid, Lithiumperoxid, Natriumperoxid, Kaliumperoxid, Magnesiumperoxid, Calciumperoxid, Bariumperoxid, Ammoniumperborat, Lithiumperborat, Kaliumperborat oder Natriumperborat eingesetzt.

Gemäß einer besonders bevorzugten Ausführungsform handelt es sich bei den anorganischen Peroxiden um Wasserstoffperoxid, Ammoniumperoxid, Natriumperoxid und Ammoniumperborat.

Als in der erfindungsgemäßen Metallpaste enthaltenes Sinterhilfsmittel können ferner auch anorganische Säuren fungieren.

Vorzugsweise handelt es sich bei den anorganischen Säuren um sauerstoffhaltige anorganische Säuren.

Gemäß einer weiteren bevorzugten Ausführungsform werden als anorganische Säuren Phosphorsäuren eingesetzt. Unter Phosphorsäuren sind allgemein anorganische Säuren zu verstehen, die wenigstens ein Phosphoratom aufweisen.

Bevorzugte Phosphorsäuren, die erfindungsgemäß als Sinterhilfsmittel eingesetzt werden können, sind ortho-Phosphorsäure, Diphosphorsäure, Metaphosphorsäuren und Polyphosphorsäuren.

Die erfindungsgemäßen Sinterhilfsmittel werden vorzugsweise als Bestandteil einer Metallpaste verwendet, die in einem Sinterprozess zum Einsatz kommt. Vorzugsweise werden bei diesem Sinterprozess Bauelemente miteinander verbunden, die in einer Sandwichanordnung über die Metallpaste miteinander in Kontakt stehen.

Die erfindungsgemäß verwendeten Metallpasten können neben Metallen, Metallprecursorn, Lösungsmitteln und Sinterhilfsmitteln auch weitere Inhaltsstoffe aufweisen.

Bei diesen weiteren Inhaltsstoffen kann es sich vorzugsweise um üblicherweise in Metallpasten eingesetzte Inhaltsstoffe handeln.

Beispielsweise können in der Metallpaste als weitere Inhaltsstoffe Dispersionsmittel, Tenside, Entschäumer, Bindemittel, Polymere oder viskositätssteuernde Mittel enthalten sein.

Die erfindungsgemäße Metallpaste enthält 75 - 90 Gewichtsprozent, vorzugsweise 77 - 89 Gewichtsprozent, mehr bevorzugt 78 - 87 Gewichtsprozent und noch mehr bevorzugt 78 - 86 Gewichtsprozent wenigstens eines der hierin beschriebenen, in Form von Partikeln vorliegenden Metalle. Diese Gewichtsangaben schließen das Gewicht der Coatingverbindungen, die auf den Partikeln enthalten sind, mit ein.

Die erfindungsgemäße Metallpaste enthält 0 -12 Gewichtsprozent, vorzugsweise 0,1 -12 Gewichtsprozent, mehr bevorzugt 1 - 10 Gewichtsprozent und noch mehr bevorzugt 2 - 8 Gewichtsprozent wenigstens eines Metallprecursors.

Die erfindungsgemäße Metallpaste enthält 6 - 20 Gewichtsprozent, vorzugsweise 7 - 18 Gewichtsprozent, mehr bevorzugt 8 - 17 Gewichtsprozent und noch mehr bevorzugt 10 - 15 Gewichtsprozent wenigstens eines Lösungsmittels.

Die erfindungsgemäße Metallpaste enthält 0,1 - 15 Gewichtsprozent, vorzugsweise 0,1 - 12 Gewichtsprozent, mehr bevorzugt 1 - 10 Gewichtsprozent und noch mehr bevorzugt 1 - 8 Gewichtsprozent wenigstens eines der hierin beschriebenen Sinterhilfsmittel.

Die erfindungsgemäße Metallpaste enthält 0 - 15 Gewichtsprozent, vorzugsweise 0 - 12 Gewichtsprozent, mehr bevorzugt 0,1 - 10 Gewichtsprozent und noch mehr bevorzugt 1 - 10 Gewichtsprozent weitere Inhaltsstoffe.

Folglich enthält die erfindungsgemäße Metallpaste 75 - 90 Gewichtsprozent wenigstens eines der hierin beschriebenen Metalle, 0 - 12 Gewichtsprozent wenigstens eines Metallprecursors, 6 - 20 Gewichtsprozent wenigstens eines Lösungsmittels und 0,1 - 15 Gewichtsprozent wenigstens eines der hierin beschriebenen Sinterhilfsmittel.

Gemäß einer bevorzugten Ausführungsform enthält die erfindungsgemäße Metallpaste 77 - 89 Gewichtsprozent wenigstens eines der hierin beschriebenen Metalle, 0,1 -12 Gewichtsprozent wenigstens eines Metallprecursors, 7 - 18 Gewichtsprozent wenigstens eines Lösungsmittels und 0,1 - 12 Gewichtsprozent wenigstens eines der hierin beschriebenen Sinterhilfsmittel.

Gemäß einer mehr bevorzugten Ausführungsform enthält die erfindungsgemäße Metallpaste 78 - 87 Gewichtsprozent wenigstens eines der hierin beschriebenen Metalle, 0,1 -10 Gewichts-prozent wenigstens eines Metallprecursors, 8 - 17 Gewichtsprozent wenigstens eines Lösungsmittels und 1 - 10 Gewichtsprozent wenigstens eines der hierin beschriebenen Sinterhilfsmittel.

Gemäß einer noch mehr bevorzugten Ausführungsform enthält die erfindungsgemäße Metallpaste 78 - 86 Gewichtsprozent wenigstens eines der hierin beschriebenen Metalle, 2 - 8 Gewichtsprozent wenigstens eines Metallprecursors, 10 - 15 Gewichtsprozent wenigstens eines Lösungsmittels und 1 - 8 Gewichtsprozent wenigstens eines der hierin beschriebenen Sinterhilfsmittel.

Gemäß einer besonders bevorzugten Ausführungsform liegt das molare Verhältnis von Sinterhilfsmitteln zu den im Coating der Metallpartikel enthaltenen organischen Verbindungen (Coatingverbindungen) im Bereich von 1 : 1 bis 100 : 1, mehr bevorzugt im Bereich von 2 : 1 bis 80 : 1, noch mehr bevorzugt im Bereich von 5 : 1 bis 80 : 1 und insbesondere im Bereich von 10 : 1 bis 70 : 1. Unter molarem Verhältnis von Sinterhilfsmitteln zu Coatingverbindungen wird erfindungsgemäß der Quotient aus (i) der Summe der Stoffmengen der in der Metallpaste enthaltenen Sinterhilfsmittel und (ii) der Summe der Stoffmengen der im Coating der Metallpartikel enthaltenen Coatingverbindungen bezeichnet. Enthält eine Metallpaste bspw. als Sinterhilfsmittel 0,025 mol Dicumylperoxid und 0,15 mol Di-tert-butyl-peroxid und als einzige Coatingverbindung 0,0008 mol Kaliumstearat, so beträgt das molare Verhältnis von Sinterhilfsmitteln zu Coatingverbindungen 50 : 1.

Ein Verhältnis von Sinterhilfsmitteln zu Coatingverbindungen im erfindungsgemäß bevorzugten Bereich hat weitere vorteilhafte Effekte zur Folge. So wird dadurch einerseits gewährleistet, dass während des Sinterprozesses als Resultat des Verbrennens der Coatingverbindungen genügend Kohlenmonoxid zur Reduktion der Metalloxide zur Verfügung steht. Andererseits ist die Menge an Sinterhilfsmitteln dann noch nicht so hoch, dass hierdurch der Sinterprozess beeinträchtigt würde.

Wie vorstehend erläutert, kann es erfindungsgemäß bevorzugt sein, wenn es sich bei den im Coating der Metallpartikel enthaltenen organischen Verbindungen um freie Fettsäuren, Fettsäuresalze oder Fettsäureester handelt, die vorzugsweise 8 - 24, mehr bevorzugt 10 - 24 und noch mehr bevorzugt 12 - 18 Kohlenstoffatome aufweisen.

Sind in der Metallpaste freie Fettsäuren, Fettsäuresalze oder Fettsäureester mit vorzugsweise 8 - 24, mehr bevorzugt 10 - 24 und noch mehr bevorzugt 12 - 18 Kohlenstoffatomen nicht nur als Coatingverbindungen, sondern auch als weitere Inhaltsstoffe in der Metallpaste enthalten, dann kann es bevorzugt sein, dass für die Bestimmung des molaren Verhältnisses von Sinterhilfsmitteln zu Coatingverbindungen der Begriff Coatingverbindungen neben den auf der Oberfläche der Metallpartikel enthaltenen Fettsäuren, Fettsäuresalze oder Fettsäureester auch die Fettsäuren, Fettsäuresalze oder Fettsäureester, die als weitere Inhaltsstoffe in der Metallpaste enthalten sind, umfasst.

Die hierin beschriebenen Metallpasten werden erfindungsgemäß in einem Sinterverfahren eingesetzt.

Unter Sintern wird vorzugsweise das Verbinden von zwei oder mehr Bauelementen durch Erhitzen unter Umgehung der flüssigen Phase verstanden.

Erfindungsgemäß wird unter dem Verbinden von wenigstens zwei Bauelementen das Befestigen von einem ersten Bauelement auf einem zweiten Bauelement verstanden. In diesem Zusammenhang bedeutet "auf" lediglich, dass eine Oberfläche des ersten Bauelements mit einer Oberfläche des zweiten Bauelements verbunden ist, wobei es auf die relative Lage der beiden Bauelemente oder der Anordnung, die die wenigstens zwei Bauelemente enthält, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Teile bezeichnet, die in der Hochleistungselektronik verwendet werden.

Demgemäß kann es sich bei den Bauelementen beispielsweise um Dioden, LEDs (light emitting diodes, lichtemittierende Dioden), DCB (direct copper bonded)-Substrate, Leadframes, Dies, IGBTs (insulated-gate bipolar transistors, Bipolartransistoren mit isolierter Gate-Elektrode), ICs (integrated circuits, integrierte Schaltungen), Sensoren, Kühlkörper (vorzugsweise AluminiumKühlkörper oder Kupfer-Kühlkörper) oder andere passive Baulemente (zum Beispiel Widerstände, Kondensatoren oder Spulen) handeln. Vorzugsweise kann es sich bei den Bauelementen auch um nichtmetallische Bauelemente handeln.

Die zu verbindenden Bauelementen können gleichartige oder verschiedenartige Bauelemente sein.

Unter bevorzugten Ausführungsformen betrifft die Erfindung die Verbindung von LED mit Leadframe, von LED mit keramischem Substrat, von Dies, Dioden, IGBTs oder ICs mit Leadframes, keramischen Substraten oder DCB-Substraten, von Sensor mit Leadframe oder keramischem Substrat, von DCB oder keramischem Substrat mit Kupfer- oder Aluminiumkühlkörper, von Leadframe mit Kühlkörper oder von Tantalkondensatoren, vorzugsweise in ungehäustem Zustand, mit Leadframe.

Ebenfalls bevorzugt können mehr als zwei Bauelemente miteinander verbunden werden. Beispielsweise können (i) LED oder Chip mit (ii) Leadframe und (iii) Kühlkörper verbunden werden, wobei sich der Leadframe vorzugsweise zwischen LED oder Chip und Kühlkörper befindet. Ebenso kann eine Diode mit zwei Kühlkörpern verbunden werden, wobei sich die Diode vorzugsweise zwischen zwei Kühlkörpern befindet.

Gemäß einer bevorzugten Ausführungsform können die Bauelemente wenigstens eine Metallisierungsschicht umfassen. Diese Metallisierungsschicht ist vorzugsweise Teil des Bauelements. Die Metallisierungsschicht befindet sich vorzugsweise an wenigstens einer Oberfläche des Bauelements.

Die Metallisierungsschicht kann reines Metall aufweisen. So kann es bevorzugt sein, wenn die Metallisierungsschicht wenigstens 50 Gewichtsprozent, mehr bevorzugt wenigstens 70 Gewichtsprozent, noch mehr bevorzugt wenigstens 90 Gewichtsprozent oder aber 100 Gewichts-prozent an reinem Metall aufweist. Das reine Metall ist vorzugsweise aus der Gruppe ausgewählt, die aus Kupfer, Silber, Gold, Palladium und Platin besteht.

Andererseits kann die Metallisierungsschicht auch eine Legierung aufweisen. Die Legierung der Metallisierungsschicht enthält vorzugsweise wenigstens ein Metall, das aus der Gruppe ausgewählt ist, die aus Silber, Gold, Nickel, Palladium und Platin besteht. Es kann auch bevorzugt sein, dass wenigstens zwei Metalle, die aus der Gruppe ausgewählt sind, die aus Silber, Gold, Nickel, Palladium und Platin besteht, in der Legierung der Metallisierungsschicht enthalten sind. Der Anteil der Elemente, die aus der Gruppe ausgewählt sind, die aus Silber, Gold, Nickel, Palladium und Platin besteht, an der Legierung beträgt vorzugsweise wenigstens 90 Gewichtsprozent, mehr bevorzugt wenigstens 95 Gewichtsprozent, noch mehr bevorzugt wenigstens 99 Gewichtsprozent, so zum Beispiel 100 Gewichtsprozent.

Gemäß einer bevorzugten Ausführungsform enthält die Metallisierungsschicht vorzugsweise wenigstens 95 Gewichtsprozent, mehr bevorzugt wenigstens 99 Gewichtsprozent und noch mehr bevorzugt 100 Gewichtsprozent dieser Legierung.

Die Metallisierungsschicht kann auch einen mehrlagigen Aufbau aufweisen. So kann es beispielsweise bevorzugt sein, wenn wenigstens eine Oberfläche der zusammenzufügenden Bauelemente eine Metallisierungsschicht aus mehreren Lagen umfasst, die die vorstehend genannten reinen Metalle und/oder Legierungen aufweisen.

Gemäß einer bevorzugten Ausführungsform umfasst wenigstens eine Metallisierungsschicht eines Bauelements, insbesondere eines DCB-Substrats, eine Lage aus Kupfer, auf der eine Lage aus Nickel aufgebracht ist. Gegebenenfalls kann auf der Lage aus Nickel nochmals eine Lage aus Gold aufgebracht sein. Die Dicke der Lage aus Nickel beträgt in diesem Fall vorzugsweise 1 - 2 µm und die Dicke der Lage aus Gold vorzugsweise 0,05 - 0,3 µm. Andererseits kann es auch bevorzugt sein, wenn eine Metallisierungsschicht eines Bauelements eine Lage aus Silber oder Gold und darüber eine Lage aus Palladium oder Platin umfasst.

Gemäß einer weiteren bevorzugten Ausführungsform enthalten die einzelnen Lagen neben den genannten reinen Metallen oder Legierungen auch ein Glas. Es kann auch bevorzugt sein, wenn die Lagen eine Mischung aus (i) Glas und (ii) den reinen Metallen oder Legierungen darstellen.

Erfindungsgemäß werden wenigstens zwei Bauelemente durch Sintern miteinander verbunden.

Dazu werden zunächst die zwei oder mehr Bauelemente miteinander in Kontakt gebracht. Das Kontaktieren erfolgt dabei über die erfindungsgemäße Metallpaste. Zu diesem Zweck wird eine Anordnung bereitgestellt, bei der sich zwischen jeweils zwei der wenigstens zwei Bauelemente Metallpaste befindet.

Sollen daher zwei Bauelemente, Bauelement 1 und Bauelement 2, miteinander verbunden werden, so befindet sich die erfindungsgemäße Metallpaste vor dem Sintern zwischen Bauelement 1 und Bauelement 2. Andererseits ist es denkbar, dass mehr als zwei Bauelemente miteinander verbunden werden. Beispielsweise können drei Bauelemente, Bauelement 1, Bauelement 2 und Bauelement 3, auf eine Weise miteinander verbunden werden, dass Bauelement 2 zwischen Bauelement 1 und Bauelement 3 liegt. In diesem Fall befindet sich die erfindungsgemäße Metallpaste sowohl zwischen Bauelement 1 und Bauelement 2 als auch zwischen Bauelement 2 und Bauelement 3.

Erfindungsgemäß vorgesehen ist, dass die einzelnen Bauelemente in einer Sandwichanordnung vorliegen und miteinander verbunden werden.

Unter Sandwichanordnung ist erfindungsgemäß eine Anordnung zu verstehen, bei der sich zwei Bauelemente übereinander befinden und die Bauelemente im Wesentlichen parallel zueinander sind.

Die Anordnung aus wenigstens zwei Bauelementen und Metallpaste, wobei sich Metallpaste zwischen zwei Bauelementen dieser Anordnung befindet, kann nach einem aus dem Stand der Technik bekannten Verfahren hergestellt werden.

Vorzugsweise wird zunächst wenigstens eine Oberfläche eines Bauelements 1 mit der erfindungsgemäßen Metallpaste versehen. Anschließend wird ein anderes Bauelement 2 mit einer seiner Oberflächen auf die Metallpaste, die auf die Oberfläche des Bauelements 1 aufgetragen worden ist, aufgesetzt.

Die Auftragung der Metallpaste auf die Oberfläche eines Bauelements kann mittels herkömmlicher Verfahren erfolgen. Vorzugsweise erfolgt die Auftragung der Metallpaste mittels Druckverfahren, so zum Beispiel mittels Siebdruck oder Schablonendruck. Andererseits kann die Auftragung der Metallpaste auch mittels Dispenstechnik, mittels Spraytechnik, mittels Pintransfer oder durch Dippen erfolgen.

Im Anschluss an die Auftragung der Metallpaste wird vorzugsweise die mit der Metallpaste versehene Oberfläche dieses Bauelements mit einer Oberfläche des damit zu verbindenden Bauelements über die Metallpaste in Kontakt gebracht. Somit befindet sich zwischen den zu verbindenden Bauelementen eine Schicht Metallpaste.

Die Nassschichtdicke zwischen den zu verbindenden Bauelementen liegt vorzugsweise im Bereich von 20 - 200 µm. Unter Nassschichtdicke wird erfindungsgemäß der Abstand zwischen den sich gegenüberliegenden Oberflächen der zu verbindenden Bauelemente vor dem Sinterprozess verstanden. Die bevorzugte Nasssichtdicke ist abhängig vom gewählten Verfahren zum Auftragen der Metallpaste. Wird die Metallpaste beispielsweise mittels Siebdruckverfahren aufgetragen, dann kann eine Nassschichtdicke von 20 - 50 µm bevorzugt sein. Erfolgt die Auftragung der Metallpaste mittels Schablonendruck, dann kann die bevorzugte Nassschichtdicke im Bereich von 50 - 200 µm liegen.

Gemäß einer bevorzugten Ausführungsform wird vor dem Sinterprozess ein Trocknungsschritt durchgeführt.

Unter Trocknung wird vorzugsweise eine Verringerung des Anteils des Lösungsmittels in der Metallpaste verstanden.

Gemäß einer bevorzugten Ausführungsform liegt der Anteil des Lösungsmittels in der Metallpaste nach der Trocknung im Bereich von 1 - 5 Gewichtsprozent, bezogen auf das Gewicht der getrockneten Metallpaste.

Die Trocknung kann einerseits nach der Herstellung der Anordnung, also nach der Kontaktierung der zu verbindenden Bauelemente erfolgen. Andererseits kann die Trocknung aber auch unmittelbar nach dem Auftragen der Metallpaste auf die wenigstens eine Oberfläche des Bauelements und vor der Kontaktierung mit dem zu verbindenden Bauelement erfolgen.

Die Trocknungstemperatur liegt vorzugsweise im Bereich von 50 -100°C.

Es versteht sich, dass die Trocknungszeit abhängig ist von der jeweiligen Zusammensetzung der Metallpaste und der Größe der zu sinternden Anordnung. Übliche Trocknungszeiten liegen im Bereich von 5 - 45 Minuten.

Die Anordnung aus den wenigstens zwei Bauelementen und zwischen den Bauelementen befindlicher Metallpaste wird schließlich erfindungsgemäß einem Sinterprozess unterzogen.

Bei diesem Sinterprozess handelt es sich um einen Niedertemperatursinterprozess.

Unter Niedertemperatursinterprozess ist erfindungsgemäß ein Sinterprozess zu verstehen, der vorzugsweise bei einer Temperatur von unter 200°C abläuft.

Der Prozessdruck liegt dabei vorzugsweise unter 30 MPa und mehr bevorzugt unter 5 MPa. Vorzugsweise liegt der Prozessdruck im Bereich von 1 - 30 MPa und mehr bevorzugt im Bereich von 1 - 5 MPa.

Die Sinterzeit ist abhängig vom Prozessdruck und liegt vorzugsweise im Bereich von 2 - 45 Minuten.

Erfindungsgemäß kann der Sinterprozess in einer Atmosphäre erfolgen, die nicht weiter eingeschränkt ist. So kann das Sintern einerseits in einer Atmosphäre durchgeführt werden, die Sauerstoff enthält. Andererseits ist es erfindungsgemäß auch möglich, das Sintern in sauerstofffreier Atmosphäre durchzuführen. Unter sauerstofffreier Atmosphäre ist im Rahmen der Erfindung eine Atmosphäre zu verstehen, deren Sauerstoffgehalt nicht mehr als 10 ppm, vorzugsweise nicht mehr als 1 ppm und noch mehr bevorzugt nicht mehr als 0,1 ppm beträgt.

Das Sintern wird in einer herkömmlichen, zum Sintern geeigneten Vorrichtung durchgeführt, in der sich die vorstehend beschriebenen Prozessparameter einstellen lassen.

Die Erfindung wird im Folgenden anhand der nachstehend aufgeführten Beispiele erläutert, die jedoch nicht als einschränkend verstanden werden sollen.

### Beispiele:

### 1. Herstellung von Metallpasten:

Zunächst wurden die erfindungsgemäßen Metallpasten 1 - 3 und die Vergleichspaste 1 durch Vermischen der einzelnen Bestandteile hergestellt.

### 1.1 l Erfindungsgemäße Metallpaste 1:

Es wurde eine Metallpaste hergestellt, die 79,7 Gewichtsprozent gecoatete Silberpartikel mit einem mittleren Teilchendurchmesser von 0,5 - 5 µm (Coatingmenge: < 2 Gewichtsprozent Natriumstearat), 5 Gewichtsprozent Silberoxid, 5,5 Gewichtsprozent Terpineol, 4,3 Gewichts-prozent Tridecanol und 5,5 Gewichtsprozent Dicumylperoxid enthielt.

### 1.2 Erfindungsgemäße Metallpaste 2:

Es wurde eine Metallpaste hergestellt, die 80 Gewichtsprozent gecoatete Silberpartikel mit einem mittleren Teilchendurchmesser von 2 - 15 µm (Coatingmenge: < 2 Gewichtsprozent Natriumstearat), 5 Gewichtsprozent Silberoxid, 6 Gewichtsprozent Di-tert-butlyperoxid, 5 Gewichts-prozent Terpineol und 4 Gewichtsprozent 1-Dodecanol enthielt.

### 1.3 Erfindungsgemäße Metallpaste 3:

Es wurde eine Metallpaste hergestellt, die 80 Gewichtsprozent gecoatete Silberpartikel mit einem mittleren Teilchendurchmesser von 0,5 - 5 µm (Coatingmenge: < 2 Gewichtsprozent Natriumstearat), 5 Gewichtsprozent Silbercarbonat, 6 Gewichtsprozent Di-tert-butylperoxid, 5 Gewichtsprozent Terpineol und 4 Gewichtsprozent 1-Isotridecanol enthielt.

### 1.4 Vergleichspaste 1:

Es wurde eine Metallpaste hergestellt, die 82 Gewichtsprozent gecoatete Silberpartikel mit einem mittleren Teilchendurchmesser von 0,5 - 5 µm (Coatingmenge: < 2 Gewichtsprozent Natriumstearat), 8,2 Gewichtsprozent Silberoxid, 5,5 Gewichtsprozent Terpineol und, 4,3 Gewichtsprozent Tridecanol enthielt. Die Vergleichspaste 1 entspricht somit der erfindungsgemäßen Metallpaste 1 mit der Abweichung, dass kein Dicumylperoxid enthalten, sondern stattdessen der Anteil an Silberpartikeln und Silberoxid erhöht ist.

### 2. Ausführungsbeispiele:

Die hergestellten Metallpasten wurden zum Sintern von zwei miteinander zu verbindenden Bauelementen verwendet.

### 2.1 Ausführungsbeispiel 1:

In diesem Beispiel wurden DCB-Substrate, die jeweils eine Metallisierungsschicht aus Silber aufwiesen, und IGBTs, die ebenfalls jeweils eine Metallisierungsschicht aus Silber enthielten, durch Sintern miteinander verbunden.

Dazu wurden auf die Metallisierungsschicht der einzelnen DCB-Substrate die erfindungsgemäßen Metallpasten 1 - 3 bzw. die Vergleichspaste 1 mittels Siebdruckverfahren aufgebracht. Im Anschluss daran wurden die einzelnen IGBTs mit der Metallisierungsschicht auf die Pasten gesetzt.

In den Fällen, in denen die erfindungsgemäßen Metallpasten 2 und 3 eingesetzt wurden, erfolgte eine Trocknung des Aufbaus aus DCB-Substrat, Metallpaste und IGBT bei 80°C für 20 Minuten. In den anderen Fällen war eine Trocknung nicht erforderlich. Die Nassschichtdicke betrug jeweils 100 µm.

Der so hergestellte Aufbau wurde für 20 Sekunden bei einem Prozessdruck von 5 MPa und unterschiedlichen Prozesstemperaturen gesintert.

### 2.2 Ausführungsbeispiel 2:

Dieses Ausführungsbeispiel entspricht Ausführungsbeispiel 1 mit der Abweichung, dass der erhaltene Aufbau für 15 Minuten druckfrei gesintert wurde.

### 2.3 Ausführungsbeispiel 3:

In diesem Beispiel wurden Leadframes, die jeweils eine Metallisierungsschicht aufwiesen, die aus einer Lage Nickel und einer Lage Gold bestanden, wobei sich an der Außenseite die Goldlage befand, und Dioden, die jeweils eine Metallisierungsschicht aus Silber enthielten, durch Sintern miteinander verbunden.

Dazu wurden auf die Metallisierungsschicht der einzelnen Leadframes die erfindungsgemäßen Metallpasten 1 - 3 bzw. die Vergleichspaste 1 mittels Schablonendruckverfahren aufgebracht. Im Anschluss daran wurden die einzelnen Dioden mit der Metallisierungsschicht auf die Pasten gesetzt.

In den Fällen, in denen die erfindungsgemäßen Metallpasten 2 und 3 eingesetzt wurden, erfolgte eine Trocknung des Aufbaus aus DCB-Substrat, Metallpaste und IGBT bei 80°C für 20 Minuten. In den anderen Fällen war eine Trocknung nicht erforderlich. Die Nassschichtdicke betrug jeweils 100 µm.

Der so hergestellte Aufbau wurde für 20 Sekunden bei einem Prozessdruck von 5 MPa und unterschiedlichen Prozesstemperaturen gesintert.

### 2.4 Ausführungsbeispiel 4:

Dieses Ausführungsbeispiel entspricht Ausführungsbeispiel 3 mit der mit der Abweichung, dass der erhaltene Aufbau für 15 Minuten druckfrei gesintert wurde.

### 3 Ergebnisse:

### 3.1 Ausführungsbeispiele 1 und 3:

In den Ausführungsbeispielen, in denen die erfindungsgemäßen Metallpasten 1 - 3 verwendet wurden, betrug die Sintertemperatur jeweils etwa 195°C. Dagegen betrug die Sintertemperatur in dem Ausführungsbeispiel, in dem die Vergleichspaste 1 verwendet wurde, etwa 230°C.

### 3.2 Ausführungsbeispiele 2 und 4:

In den Ausführungsbeispielen, in denen die erfindungsgemäßen Metallpasten 1 - 3 verwendet wurden, betrug die Sintertemperatur jeweils etwa 185°C. Dagegen betrug die Sintertemperatur in dem Ausführungsbeispiel, in denen die Vergleichspaste 1 verwendet wurde, etwa 230°C.

## Patentansprüche

1. Metallpaste enthaltend
(A) 75 - 90 Gewichtsprozent wenigstens eines Metalls, das in Form von Partikeln vorliegt, die ein Coating aufweisen, das wenigstens eine organische Verbindung enthält,
(B) 0 - 12 Gewichtsprozent wenigstens eines Metallprecursors,
(C) 6 - 20 Gewichtsprozent wenigstens eines Lösungsmittels und
(D) 0,1 - 15 Gewichtsprozent wenigstens eines Sinterhilfsmittels, das aus der Gruppe ausgewählt ist, bestehend aus
(i) organischen Peroxiden,
(ii) anorganischen Peroxiden und
(iii) anorganischen Säuren.

2. Metallpaste nach Anspruch 1, **dadurch gekennzeichnet, dass** das organische Peroxid aus der Gruppe ausgewählt ist, die aus Diisobutyryl-peroxid, Cumol-peroxyneodecanoat, 1,1,3,3-Tetramethylbutyl-peroxyneodecanoat, Di-n-propyl-peroxydicarbonat, tert-Amyl-peroxyneodecanoat, Di-(2-ethylhexyl)-peroxydicarbonat, tert-Butyl-peroxyneodecanoat, Di-n-butyl-peroxydicarbonat, 1,1,3,3-Tetramethylbutylperoxypivalat, tert-Butylperoxyneoheptanoat, tert-Amyl-peroxypivalat, tert-Butyl-peroxypivalat, Di-(3,5,5-trimethylhexanoyl)-peroxid, tert-Butyl-peroxy-2-ethylhexanoat, tert-Butyl-peroxyisobutyrat, 1,1-Di-(tert-butylperoxy)-3,3,5-trimethylcyclohexan, 1,1-Di-(tert-butylperoxy)-cyclohexan, tert-Butyl-peroxy-3,5,5-trimethylhexanoat, 2,2-Di-(tert-butylperoxy)-butan, tert-Butylperoxyisopropylcarbonat, tert-Butyl-peroxyacetat, 2,5-Dimethyl-2,5-di(2-ethylhexanoylperoxy)-hexan, 1,1,3,3-Tetramethylbutyl-peroxy-2-ethylhexanoat, tert-Amyl-peroxy-2-ethylhexanoat, tert-Butyl-peroxydiethylacetat, tert-Amyl-peroxy-2-ethylhexylcarbonat,tert-Butyl-peroxy-2-ethylhexylcarbonat, tert-Butyl-peroxybenzoat, Di-tert-amylperoxid, 2,5-Dimethyl-2,5-di-(tert-butylperoxy)-hexan, tert-Butylcumyl-peroxid, 2,5-Dimethyl-2,5-di(tert-butylperoxy)hexyn-3, Di-tert-butyl-peroxid, 3,6,9-Triethyl-3,6,9-trimethyl-1,4,7-triperoxonan, Di-isopropylbenzen-mono-hydroperoxid, p-Menthanhydroperoxid, Cumolhydroperoxid, Dicumylperoxid und 1,1,3,3-Tetramethylbutyl-hydroperoxid besteht.

3. Metallpaste nach Anspruch 1, **dadurch gekennzeichnet, dass** das anorganische Peroxid aus der Gruppe ausgewählt ist, die aus Wasserstoffperoxid, Ammoniumperoxid, Lithiumperoxid, Natriumperoxid, Kaliumperoxid, Magnesiumperoxid, Calciumperoxid, Bariumperoxid und Peroxoboraten besteht.

4. Metallpaste nach Anspruch 1, **dadurch gekennzeichnet, dass** die anorganische Säure eine Phosphorsäure ist.

5. Metallpaste nach einem der Ansprüche 1 - 4, **dadurch gekennzeichnet, dass** die wenigstens eine organische Verbindung aus der Gruppe ausgewählt ist, die aus freien Fettsäuren, Fettsäuresalzen und Fettsäureestern, die jeweils 8 - 24 Kohlenstoffatome aufweisen, besteht.

6. Metallpaste nach einem der Ansprüche 1 - 5, **dadurch gekennzeichnet, dass** das molare Verhältnis von Sinterhilfsmitteln zu den im Coating enthaltenen organischen Verbindungen im Bereich von 1 : 1 bis 100 : 1 liegt.

7. Verwendung eines Sinterhilfsmittels, das aus der Gruppe ausgewählt ist, bestehend aus
(i) organischen Peroxiden, -
(ii) anorganischen Peroxiden und
(iii) anorganischen Säuren,
für einen Sinterprozess zum Verbinden von Bauelementen, die in einer Sandwichanordnung über die Metallpaste miteinander in Kontakt stehen.

8. Verfahren zum Verbinden von wenigstens zwei Bauelementen, bei dem man
(a) eine Sandwichanordnung bereitstellt, die wenigstens
(a1) ein Bauelement 1,
(a2) ein Bauelement 2 und
(a3) eine Metallpaste aufweist, die sich zwischen Bauelement 1 und Bauelement 2 befindet, und
(b) die Sandwichanordnung sintert,
**dadurch gekennzeichnet, dass** die Metallpaste
(A) 75 - 90 Gewichtsprozent wenigstens eines Metalls, das in Form von Partikeln vorliegt, die ein Coating aufweisen, das wenigstens eine organische Verbindung enthält,
(B) 0 - 12 Gewichtsprozent wenigstens eines Metallprecursors,
(C) 6 - 20 Gewichtsprozent wenigstens eines Lösungsmittels und
(D) 0,1 - 15 Gewichtsprozent wenigstens eines Sinterhilfsmittels, das aus der Gruppe ausgewählt ist, bestehend aus
(i) organischen Peroxiden,
(ii) anorganischen Peroxiden und
(iii) anorganischen Säuren,
umfasst.

9. Verfahren nach Anspruch 8, **dadurch gekennzeichnet, dass** das Sintern bei einer Temperatur von weniger als 200°C stattfindet.

## Claims

1. Metal paste containing
(A) 75 - 90 % by weight of at least one metal that is present in the form of particles that comprise a coating that contains at least one organic compound;
(B) 0 -12 % by weight of at least one metal precursor;
(C) 6 - 20 % by weight of at least one solvent; and
(D) 0.1 -15 % by weight of at least one sintering aid selected from the group consisting of
(i) organic peroxides;
(ii) inorganic peroxides; and
(iii) inorganic acids.

2. Metal paste according to claim 1, **characterised in that** the organic peroxide is selected from the group consisting of diisobutyryl-peroxide, cumene-peroxyneodecanoate, 1,1,3,3-tetramethylbutyl-peroxyneodecanoate, di-n-propyl-peroxydicarbonate, tert-amyl- peroxyneodecanoate, di-(2-ethylhexyl)-peroxydicarbonate, tert-butyl-peroxyneodecanoate, di-n-butyl-peroxydicarbonate, 1,1,3,3-tetramethylbutylperoxypivalate, tert-butyl-peroxyneoheptanoate, tert-amyl-peroxypivalate, tert-butyl-peroxypivalate, di-(3,5,5- trimethylhexanoyl)-peroxide, tert-butyl-peroxy-2-ethylhexanoate, tert-butyl-peroxyisobutyrate, 1,1-di-(tert-butylperoxy)-3,3,5-trimethylcyclohexane, 1,1-di-(tert- butylperoxy)-cyclohexane, tert-butyl-peroxy-3,5,5-trimethylhexanoate, 2,2-di-(tert- butylperoxy)-butane, tert-butylperoxyisopropylcarbonate, tert-butyl-peroxyacetate, 2,5-dimethyl-2,5-di(2-ethylhexanoylperoxy)-hexane, 1,1,3,3-tetramethylbutyl-peroxy-2-ethylhexanoate, tert-amyl-peroxy-2-ethylhexanoate, tert-butyl-peroxydiethylacetate, tert-amyl-peroxy-2-ethylhexylcarbonate, tert-butyl-peroxy-2-ethylhexylcarbonate, tert-butyl-peroxybenzoate, di-tert-amylperoxide, 2,5-dimethyl-2,5-di-(tert-butylperoxy)-hexane, tert-butylcumylperoxide, 2,5-dimethyl-2,5-di(tert-butylperoxy)hexyn-3, di-tert-butyl-peroxide, 3,6,9-triethyl-3,6,9-trimethyl-1,4,7-triperoxonane, di-isopropylbenzen-mono-hydroperoxide, p-menthanhydroperoxide, cumenehydroperoxide, dicumyl peroxide, and 1,1,3,3-tetramethylbutyl-hydroperoxide.

3. Metal paste according to claim 1, **characterised in that** the inorganic peroxide is selected from the group consisting of hydrogen peroxide, ammonium peroxide, lithium peroxide, sodium peroxide, potassium peroxide, magnesium peroxide, calcium peroxide, barium peroxide, and peroxoborates.

4. Metal paste according to claim 1, **characterised in that** the inorganic acid is a phosphoric acid.

5. Metal paste according to any one of the claims 1 - 4, **characterised in that** the at least one organic compound is selected from the group consisting of free fatty acids, fatty acid salts, and fatty acid esters each having 8 - 24 carbon atoms.

6. Metal paste according to any one of the claims 1 - 5, **characterised in that** the molar ratio of sintering aid to organic compounds contained in the coating is in the range of 1 : 1 to 100 : 1.

7. Use of a sintering aid selected from the group consisting of
(i) organic peroxides;
(ii) inorganic peroxides; and
(iii) inorganic acids;
for a sintering process for connecting components that contact each other through the metal paste in a sandwich arrangement.

8. Method for connecting at least two components, wherein
(a) a sandwich arrangement is provided that comprises at least
(a1) one component 1;
(a2) one component 2; and
(a3) a metal paste that is situated between component 1 and component 2, and
(b) the sandwich arrangement is being sintered,
**characterised in that** the metal paste contains
(A) 75 - 90 % by weight of at least one metal that is present in the form of particles that comprise a coating that contains at least one organic compound;
(B) 0 -12 % by weight of at least one metal precursor;
(C) 6 - 20 % by weight of at least one solvent; and
(D) 0.1 -15 % by weight of at least one sintering aid selected from the group consisting of
(i) organic peroxides;
(ii) inorganic peroxides; and
(iii) inorganic acids.

9. Method according to claim 8, **characterised in that** the sintering proceeds at a temperature of less than 200°C.

## Revendications

1. Pâte métallique contenant
(A) 75 à 90 pour cent en poids d'au moins un métal qui est présent sous la forme de particules qui présentent un revêtement qui contient au moins un composé organique,
(B) 0 à 12 pour cent en poids d'au moins un précurseur métallique,
(C) 6 à 20 pour cent en poids d'au moins un solvant et
(D) 0,1 à 15 pour cent en poids d'au moins un auxiliaire de frittage qui est sélectionné parmi le groupe constitué de
(i) peroxydes organiques,
(ii) peroxydes inorganiques et
(iii) acides inorganiques.

2. Pâte métallique selon la revendication 1, **caractérisée en ce que** le peroxyde organique est sélectionné parmi le groupe qui se compose du peroxyde de diisobutyryle, du peroxynéodécanoate de cumène, du 1,1,3,3-tétraméthylbutyle-peroxynéodécanoate, du di-n-propyle-peroxydicarbonate, du peroxynéodécanoate de tert-amyle, du di-(2-éthylhexyle)-peroxydicarbonate, du peroxynéodécanoate de tert-butyle, du di-n-butyle-peroxydicarbonate, du 1,1,3,3-tétraméthylbutyleperoxypivalate, du peroxynéoheptanoate de tert-butyle, du peroxypivalate de tert-amyle, du peroxypivalate de tert-butyle, du di-(3,5,5-triméthylhexanoyle)-peroxyde, du peroxy-2-éthylhexanoate de tert-butyle, du peroxyisobutyrate de tert-butyle, du 1,1-di-(tert-butylperoxy)-3,3,5-triméthylcyclohexane, du 1,1-di-(tert-butylperoxy)-cyclohexane, du peroxy-3,5,5-triméthylhexanoate de tert-butyle, du 2,2-di-(tert-butylperoxy)-butane, du peroxyisopropylcarbonate de tert-butyle, du peroxyacétate de tert-butyle, du 2,5-diméthyl-2,5-di(2-éthylhexanoylperoxy)-hexane, du 1,1,3,3-tétraméthylbutyl-peroxy-2-éthylhexanoate, du peroxy-2-ethylhexanoate de tert-amyle, du peroxydiéthylacetate de tert-butyle, du peroxy-2-éthylhexylcarbonate de tert-amyle, du peroxy-2-éthylhexylcarbonate de tert-buytle, du peroxybenzoate de tert-butyle, du di-tert-amylperoxyde, du 2,5-diméthyl-2,5-di-(tert-butylperoxy)-hexane, du tert-butylcumyl-peroxyde, du 2,5-diméthyl-2,5-di(tert-butylperoxy)hexyne-3, du di-tert-butyl-peroxyde, du 3,6,9-triéthyl-3,6,9-triméthyl-1,4,7-triperoxonane, du di-isopropylbenzène-mono-hydroperoxyde, du p-menthanhydroperoxyde, de l'hydroxyperoxyde de cumène, du dicumylperoxyde et du 1,1,3,3-tétraméthylbutyl-hydroperoxyde.

3. Pâte métallique selon la revendication 1, **caractérisée en ce que** le peroxyde inorganique est sélectionné parmi le groupe qui se compose du peroxyde d'hydrogène, du peroxyde d'ammonium, du peroxyde de lithium, du peroxyde de sodium, du peroxyde de potassium, du peroxyde de magnésium, du peroxyde de calcium, du peroxyde de baryum et de peroxoborates.

4. Pâte métallique selon la revendication 1, **caractérisée en ce que** l'acide inorganique est un acide phosphorique.

5. Pâte métallique selon l'une quelconque des revendications 1 à 4, **caractérisée en ce que** l'au moins un composé organique est sélectionné parmi le groupe qui se compose d'acides gras, de sels d'acide gras et d'esters d'acide gras libres qui présentent chacun 8 à 24 atomes de carbone.

6. Pâte métallique selon l'une quelconque des revendications 1 à 5, **caractérisée en ce que** le rapport molaire entre auxiliaires de frittage et les composés organiques contenus dans le revêtement se situe dans la plage de 1/1 à 100/1.

7. Utilisation d'un auxiliaire de frittage qui est sélectionné parmi le groupe constitué de
(i) peroxydes organiques,
(ii) peroxydes inorganiques et
(iii) acides inorganiques,
pour un processus de frittage pour la connexion de composants qui sont en contact entre eux dans un agencement en sandwich au-dessus de la pâte métallique.

8. Procédé de connexion d'au moins deux composants, lors duquel on fournit
(a) un agencement en sandwich qui présente au moins
(a1) un composant 1,
(a2) un composant 2 et
(a3) une pâte métallique qui se trouve entre le composant 1 et le composant 2, et
(b) fritte l'agencement en sandwich,
**caractérisé en ce que** la pâte métallique comprend
(A) 75 à 90 pour cent en poids d'au moins un métal qui est présent sous la forme de particules qui présentent un revêtement qui contient au moins un composé organique,
(B) 0 à 12 pour cent en poids d'au moins un précurseur métallique,
(C) 6 à 20 pour cent en poids d'au moins un solvant et
(D) 0,1 à 15 pour cent en poids d'au moins un auxiliaire de frittage qui est sélectionné parmi le groupe constitué de
(i) peroxydes organiques,
(ii) peroxydes inorganiques et
(iii) acides inorganiques.

9. Procédé selon la revendication 8, **caractérisé en ce que** le frittage a lieu à une température inférieure à 200°C.
